# EUROPÄISCHE PATENTSCHRIFT

(11) **EP 3 192 097 B1**
(45) Veröffentlichungstag und Bekanntmachung des Hinweises auf die Patenterteilung: **06.11.2019**
(21) Anmeldenummer: 15762975.9
(22) Anmeldetag: 09.09.2015
(51) Int. Cl.: H01L 23/373, H01L 23/498, H05K 1/03, H05K 3/00

(54) **MEHRLAGENKÜHLER**
MULTILAYER COOLER
REFROIDISSEUR MULTICOUCHE

(30) Priorität: 09.09.2014 DE 102014217978
(43) Veröffentlichungstag der Anmeldung: 19.07.2017
(60) Teilanmeldung: 18213167.2
(73) Patentinhaber: CeramTec GmbH, 73207 Plochingen (DE)
(72) Erfinder: DOHN, Alexander, 96117 Memmelsdorf (DE); DILSCH, Roland, 95199 Thierstein (DE); LENEIS, Roland, 95615 Marktredwitz (DE)
(74) Vertreter: Fehrenbacher, Eckhard Anton
(86) Internationale Anmeldenummer: PCT/EP2015/070618
(87) Internationale Veröffentlichungsnummer: WO 2016/038094

(56) Entgegenhaltungen:
- EP-A2- 1 320 286
- WO-A2-2007/107601
- DE-A1- 10 035 170
- JP-A- 2000 058 381
- US-A1- 2002 025 439
- US-A1- 2002 181 185
- US-A1- 2003 218 870

## Beschreibung

Die Erfindung betrifft ein Verfahren zur Herstellung eines keramischen Trägerkörpers mit Kühlelementen und mit versinterten Metallisierungsbereichen, sowie einen keramischen Trägerkörper mit Kühlelementen und mit versinterten Metallisierungsbereichen.

Luft- oder flüssigkeitsgekühlte keramische Trägerkorper aus Al₂O₃ oder AIN tragen an der Oberflache eine strukturierte Metallisierung (Cu oder Cu-Ni-Au, oder W-Ni-Au) auf die direkt Schaltungsbauteile gelötet werden können. Mit zunehmender Miniaturisierung oder zunehmender Schaltfrequenz bei Leistungsbauteilen können weitere Schaltungselemente wie Abschirmungen, Spulen, Kondensatoren in unmittelbarer Nähe der Bauteile auf der Oberfläche des Trägers notwendig werden. Durch die zwischenzeitlich gestiegenen Schaltfrequenzen wird hochfrequente Störstrahlung erzeugt, welche zur Vermeidung von EMV Problemen aufwändig abgeschirmt werden muss.

DE 100 35 170 A1 beschreibt einen Keramikkörper mit Temperiervorrichtung und ein Verfahren zum Herstellen des Keramikkörpers.

Der Erfindung liegt daher die Aufgabe zugrunde, einen keramischen Trägerkörper mit Kühlelementen und mit versinterten Metallisierungsbereichen so weiterzubilden, dass mehr Platz für weitere Schaltungselemente (Spulen, Kondensatoren) zur Verfügung steht und/oder die zur Abschirmung der Schaltungen notwendigen zusätzlichen Schaltungselemente untergebracht werden können.

Erfindungsgemäß wird diese Aufgabe durch das im Anspruch 1 beschriebene Verfahren zur Herstellung eines keramischen Trägerkörpers gelöst.

Der erfindungsgemäße keramische Trägerkörper ist gekennzeichnet durch Kühlelemente und versinterte Metallisierungsbereiche, die in zumindest zwei Metallisierungsebenen übereinander angeordnet sind, wobei der Trägerkörper eine Oberfläche aufweist, auf der in einer ersten Metallisierungsebene versinterte Metallisierungsbereiche angeordnet sind, die elektronische Bauelemente tragen und/oder so strukturiert sind, dass sie Widerstände oder Spulen bilden und diese Metallisierungsbereiche zusammen mit den Bauelementen und/oder den gebildeten Widerständen oder Spulen von einer keramischen Platte abgedeckt sind und optional auf der keramischen Platte weitere von diesen versinterten Metallisierungsbereichen in weiteren Metallisierungsebenen angeordnet sind und jeweils mit einer keramischen Platte agedeckt sind und auf der obersten, den Kühlelementen abgewandten keramischen Platte versinterte Metallisierunsbereiche in einer Metallisierungsebene zur Aufnahme von Schaltungselementen angeordnet sind.

Um auf dem begrenzten Platz weitere Schaltungselemente (Spulen, Kondensatoren) oder zur Abschirmung der Schaltungen notwendige zusätzliche Schaltungselemente unterbringen zu können, wird somit erfindungsgemäß mindestens eine zusätzliche Metallisierungsebene zwischen Schaltungsebene und Kühlebene (Finnen oder Ebene mit flüssigem Kühlmedium) eingebracht. Diese abgedeckte Metallisierung kann aus dem gleichem Material bestehen, wie die äußere Schaltungsebene, oder auch aus einem anderen, vorzugsweise höher schmelzenden Metall. Ein Kontakt zwischen den metallischen Elementen außen und im Inneren kann durch Vias (gestanzt, lasergebohrt) oder durch bis zum Rand der Keramik herausgezogene und außen verbundene Strukturen hergestellt werden. Diese innere Lage kann zudem strukturiert werden. Sie verbessert das Störverhalten und kann elektronische Bauteile aufnehmen. Durch geeignete Strukturierung und Metallwahl lassen sich Widerstände und Spulen realisieren. Diese innere Lage kann zusammen mit der Deckschicht Kapazitäten ausbilden, die durch die Geometrie und den Abstand bestimmt werden.

Die Kühlelemente sind entweder Finnen am Trägerkörper oder Kühlkanäle im inneren des Trägerkörpers.

In bevorzugter erfinderischen Weiterbildung tragen die zusätzliche/n Metallisierungsebene/n elektronische Bauelemente trägt/tragen und/oder sind so strukturiert, dass sie Widerstände oder Spulen bildet/bilden.Die Bauelemente werden dabei so in die Metallisierung eingebaut, dass alles mit einer keramischen Platte abgedeckt werden kann. Wenn die Metallisierung bzw. die Metallisierungsbereiche so strukturiert ist/sind, dass sie Widerstände oder Spulen bildet, bildet die Metallisierung eine Ebene, auf die leicht eine keramische Platte gelegt werden kann.

Der Trägerkörper besteht bevorzugt aus den keramischen Materialien Aluminiumoxid Al2O3 oder Aluminiumnitrid AlN. Beide Werkstoffe haben eine gute Wärmeleitung und sind elektrisch nicht leitend. Die Metalliesierungsbereiche können mit diesen Materialien leich versintert werden.

Die oberste Metallisierungsebene zur Aufnahme der Schaltungselemente besteht bevorzugt aus Kupfer und die inneren Metallisierungsebenen aus Wolfram.

Ein erfindungsgemäßes Verfahren zur Herstellung eines erfindungsgemäßen Trägerkörpers ist dadurch gekennzeichnet, dass zur Herstellung einer Metallisierungsebene nach der Herstellung des keramischen Trägerkörpers mit den Kühlelementen
a) Teilbereiche der Oberfläche des Trägerkörpers mit einer Wolfram-Glas-Paste im Siebdruck beschichtet werden, wobei an zumindest einer Stelle die Wolfram-Glas-Paste bis an die Außenkante des Trägerkörpers gedruckt wird,
b) anschließend die nicht beschichteten Flächen mit einer Isolierpaste bedruckt werden, danach die Wolfram-Glas-Paste und die Isolierpaste entbindert werden,
c) anschließend eine geschliffene keramische Platte auf die entbinderten Pasten gelegt wird
d) und dann optional die Verfahrensschritte a, b und c wiederholt werden, wobei dann die keramische Platte bedruckt wird und
e) zum Schluss zur Schaffung von Seiten-Metallisierungenen mit einem weiteren Siebdruckschritt mit Kupferpaste auf die Seitenfläche des Trägerkörpers die inneren Wolfram Metallisierungen mit der obersten Kupfer Metallisierung verbunden werden.

Die einzelnen Verfahrensschritte sind allgemein bekannt. Anstatt oder zusätzlich zu den Seiten-Metallisierungenen zwischen den Metallisierungsebenen können auch VIAS zur elektrischen Verbindung der inneren Wolfram Metallisierungen mit der obersten Kupfer Metallisierung eingebracht werden.

### Beispiel:

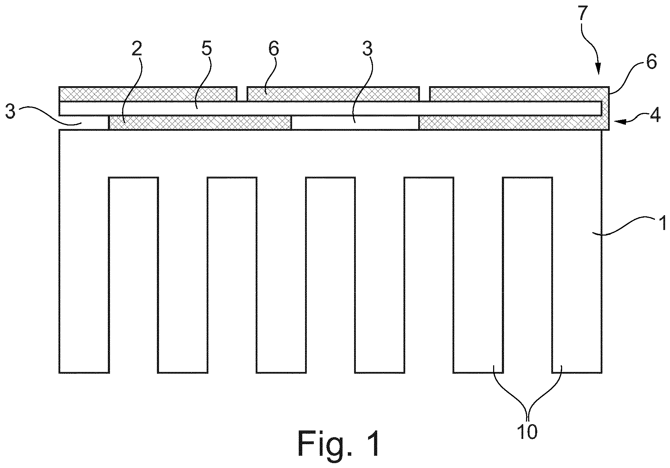

Ein geschliffener Kühlkörper 1 mit Finnen 10 (siehe Figur 1) aus AIN mit einer Größe von 40^{∗}40^{∗}30 mm wird auf der Oberfläche mit einer Wolfram-Glas-Paste 2 im Siebdruck in Kondensatorform 15 µm hoch beschichtet. Mit einem hierzu komplementären Sieb wird mit einer Isolierpaste 3 die restliche Fläche bedruckt (enthält ein Glas oder die gleiche Keramik, aus der auch der Kühlkörper 1 besteht). Die Wolfram-Glas-Paste 2 wird an einer Stelle 4 bis an die Außenkante des Kühlkörpers 1 gedruckt.

Die Wolfram-Glas-Paste 2 und die Isolierpaste 3 werden bei 500°C entbindert. Eine geschliffene keramische Platte 5 aus AIN mit einer Abmessung von 40^{∗}40^{∗}2 mm wird auf den Kühlkörper 1, bzw. auf die entbinderte Wolfram-Glas-Paste 2 und die Isolierpaste 3 aufgelegt und mit dem bedruckten Kühlkörper 1 bei 1300°C in feuchtem Stickstoff-Wasserstoff aufgebrannt. Dabei verbinden sich die beiden keramischen Teile, d.h. der Kühlkörper 1 mit seinen Finnen 10 und die keramische Platte 5. Die gebrannte Wolfram-Glas-Paste 2 bildet dann eine Zwischenschicht bzw. eine Metallisierung aus Wolfram. Diese Zwischenschicht wird auch als Metallisierungsbereich genannt und bildet eine Metallisierungsebene.

Auf die Oberseite der Platte 5 aus AIN wird mit Kupferpaste 6 ein Motiv bzw. eine Metallisierung gedruckt. Die Schichtdicke der Kupferpaste 6 liegt vorzugsweise zwischen 15 und 300 µm. Der Kupferdruck bzw. die Kupferpaste 6 reicht bis an die Außenkante 7 der Platte 5 und wird mit einem weiteren Siebdruckschritt mit Kupferpaste 6 auf die Seitenfläche mit dem Wolfram der Zwischenschicht verbunden.

Bei 910°C wird in Stickstoff die Kupferpaste 6 bzw. die Kupfermetallisierung eingebrannt.

Die Erfindung beschreibt somit auch einen keramischen Trägerkörper mit Kühlelementen und einer Schaltungsebene, die aus versinterten Metallisierungsbereichen zur Aufnahme von Schaltungselementen besteht, wobei zwischen der Schaltungsebene und dem Trägerkörper zumindest eine zusätzliche Metallisierungsebene mit versinterten Metallisierungen angeordnet ist, wobei jede dieser zusätzlichen Metallisierungen von einer keramischen Platte abgedeckt ist und die Metallisierungen der Schaltungsebene mit der obersten, den Kühlelementen abgewandten keramischen Platte versintert sind und die versinterten Metallisierungen der Metallisierungsebenen mit den Metallisierungen der Schaltungsebene über Vias oder durch bis zum Rand der Keramik herausgezogene und außen verbundene elektrisch leitende Strukturen miteinander verbunden ist/sind.

## Patentansprüche

1. Verfahren zur Herstellung eines keramischen Trägerkörpers (1) mit Kühlelementen und mit versinterten Metallisierungsbereichen, die in zumindest zwei Metallisierungsebenen übereinander angeordnet sind, wobei der Trägerkörper (1) eine Oberfläche aufweist, auf der in einer ersten Metallisierungsebene versinterte Metallisierungsbereiche angeordnet sind, die elektronische Bauelemente tragen und/oder so strukturiert sind, dass sie Widerstände oder Spulen bilden und diese Metallisierungsbereiche zusammen mit den Bauelementen und/oder den gebildeten Widerständen oder Spulen von einer keramischen Platte (5) abgedeckt sind und optional auf der keramischen Platte weitere von diesen versinterten Metallisierungsbereichen in weiteren Metallisierungsebenen angeordnet sind und jeweils mit einer keramischen Platte abgedeckt sind und auf der obersten, den Kühlelementen abgewandten keramischen Platte (5) versinterte Metallisierungsbereiche in einer Metallisierungsebene zur Aufnahme von Schaltungselementen angeordnet sind,
**dadurch gekennzeichnet, dass** zur Herstellung einer Metallisierungsebene nach der Herstellung des keramischen Trägerkörpers (1) mit den Kühlelementen
a) Teilbereiche der Oberfläche des Trägerkörpers mit einer Wolfram-Glas-Paste im Siebdruck beschichtet werden, wobei an zumindest einer Stelle die Wolfram-Glas-Paste bis an die Außenkante des Trägerkörpers gedruckt wird,
b) anschließend die nicht beschichteten Flächen mit einer Isolierpaste bedruckt werden, danach die Wolfram-Glas-Paste und die Isolierpaste entbindert werden,
c) anschließend eine geschliffene keramische Platte auf die entbinderten Pasten gelegt wird
d) und dann optional die Verfahrensschritte a, b und c wiederholt werden, wobei dann die keramische Platte bedruckt wird und
e) zum Schluss zur Schaffung von Seiten-Metallisierungen mit einem weiteren Siebdruckschritt mit Kupferpaste auf die Seitenfläche des Trägerkörpers die inneren Wolfram Metallisierungen mit der obersten Kupfer Metallisierung verbunden werden.

2. Verfahren nach Anspruch 2, **dadurch gekennzeichnet, dass** anstatt oder zusätzlich zu den Seiten-Metallisierungen zwischen den Metallisierungsebenen VIAS zur elektrischen Verbindung der inneren Wolfram Metallisierungen mit der obersten Kupfer Metallisierung eingebracht werden.

3. Keramischer Trägerkörper (1), hergestellt mit dem Verfahren nach Anspruch 1 oder 2, **dadurch gekennzeichnet, dass** der Trägerkörper Seiten-Metallisierungen aufweist und Metallisierungsbereiche bis an die Außenkante des Trägerkörpers reichen.

4. Trägerkörper nach Anspruch 3, **dadurch gekennzeichnet, dass** die Kühlelemente Finnen (10) am Trägerkörper (1) oder Kühlkanäle im inneren des Trägerkörpers (1) sind.

5. Trägerkörper nach Anspruch 3 oder 4, **dadurch gekennzeichnet, dass** die zusätzliche/n Metallisierungsebene/n elektronische Bauelemente trägt/tragen und/oder so strukturiert ist/sind, dass sie Widerstände oder Spulen bildet/bilden.

6. Trägerkörper nach einem der Ansprüche 3 bis 5, **dadurch gekennzeichnet, dass** der Trägerkörper aus den keramischen Materialien Aluminiumoxid Al2O3 oder Aluminiumnitrid AlN besteht.

7. Trägerkörper nach einem der Ansprüche 3 bis 6, **dadurch gekennzeichnet, dass** die oberste Metallisierungsebene zur Aufnahme der Schaltungselemente aus Kupfer besteht und die anderen inneren Metallisierungsebenen aus Wolfram bestehen.

## Claims

1. Method for producing a ceramic carrier body (1) comprising cooling elements and sintered metallization regions which are arranged one above the other in at least two metallization planes, the carrier body (1) having a surface on which sintered metallization regions are arranged in a first metallization plane, which metallization regions carry electronic components and/or are structured in such a way that they form resistors or coils, and these metallization regions, together with the components and/or the formed resistors or coils, being covered by a ceramic plate (5) and further regions of these sintered metallization regions being optionally arranged on the ceramic plate in other metallization planes and each being covered by a ceramic plate and sintered metallization regions being arranged on the uppermost ceramic plate (5), facing away from the cooling elements, in a metallization plane for receiving circuit elements, **characterized in that**, in order to produce a metallization plane after producing the ceramic carrier body (1) which has the cooling elements,
a) portions of the surface of the carrier body are coated with a tungsten-glass paste during screen printing, the tungsten-glass paste being printed up to the outer edge of the carrier body at at least one point,
b) the uncoated faces are subsequently printed with an insulating paste, after which the tungsten-glass paste and the insulating paste are debound,
c) a polished ceramic plate is then placed on the debound pastes
d) and then the method steps a, b and c are optionally repeated, the ceramic plate then being printed and
e) finally, in order to create side metallizations, the inner tungsten metallizations are connected to the uppermost copper metallization by means of another screen printing step using copper paste on the side face of the carrier body.

2. Method according to claim 2, **characterized in that** instead of or in addition to the side metallizations, vias are introduced between the metallization planes in order to electrically connect the inner tungsten metallizations to the uppermost copper metallization.

3. Ceramic carrier body (1), produced using the method according to either claim 1 or claim 2, **characterized in that** the carrier body has side metallizations and metallization regions extend to the outer edge of the carrier body.

4. Carrier body according to claim 3, **characterized in that** the cooling elements are fins (10) on the carrier body (1) or cooling channels in the interior of the carrier body (1).

5. Carrier body according to either claim 3 or claim 4, **characterized in that** the additional metallization plane(s) carries/carry electronic components and/or is/are structured so as to form resistors or coils.

6. Carrier body according to any of claims 3 to 5, **characterized in that** the carrier body consists of the ceramic materials aluminum oxide Al2O3 or aluminum nitride AIN.

7. Carrier body according to any of claims 3 to 6, **characterized in that** the uppermost metallization plane for receiving the circuit elements consists of copper, and the other inner metallization planes consist of tungsten.

## Revendications

1. Procédé de fabrication d'un corps de support (1) en céramique avec des éléments de refroidissement et des zones de métallisation frittées qui sont disposées l'une au-dessus de l'autre dans au moins deux niveaux de métallisation, le corps de support (1) présentant une surface sur laquelle sont disposées dans un premier niveau de métallisation des zones de métallisation frittées qui portent des composants électroniques et/ou sont structurées de sorte que des résistances ou des bobines sont formées et que ces zones de métallisation ainsi que les composants et/ou les résistances ou bobines formées sont couvertes par une plaque céramique (5) et que d'autres de ces zones de métallisation frittées sont éventuellement disposées sur la plaque en céramique dans d'autres niveaux de métallisation et respectivement couvertes d'une plaque en céramique et que des zones de métallisation frittées sont disposées dans un niveau de métallisation sur la plaque en céramique (5) supérieure, opposée aux éléments de refroidissement pour recevoir les éléments de circuit, **caractérisé en ce que**, pour fabriquer un niveau de métallisation après la fabrication du corps de support (1) en céramique avec les éléments de refroidissement,
a) des zones partielles de la surface du corps de support sont revêtues par sérigraphie d'une pâte de verre tungstène, la pâte de verre tungstène étant imprimée en au moins un point jusqu'au bord extérieur du corps de support,
b) les surfaces non revêtues sont ensuite imprimées avec une pâte isolante, puis la pâte de verre tungstène et la pâte isolante sont enlevées,
c) une plaque en céramique rectifiée est ensuite placée sur les pâtes décollées,
d) puis les étapes a, b et c du procédé sont éventuellement répétées, la plaque en céramique étant ensuite imprimée et
e) enfin, pour créer des métallisations latérales avec une autre étape de sérigraphie utilisant de la pâte de cuivre sur la surface latérale du corps du support, les métallisations intérieures en tungstène sont alliées avec la métallisation supérieure en cuivre.

2. Procédé selon la revendication 2, **caractérisé en ce qu'**au lieu ou en plus des métallisations latérales entre les niveaux de métallisation, des VIAS sont posés pour relier électriquement les métallisations intérieures en tungstène avec la métallisation supérieure en cuivre.

3. Corps de support (1) en céramique, fabriqué avec le procédé selon la revendication 1 ou 2, **caractérisé en ce que** le corps de support présente des métallisations latérales et que les zones de métallisation s'étendent jusqu'au bord extérieur du corps de support.

4. Corps de support selon la revendication 3, **caractérisé en ce que** les éléments de refroidissement sont des ailettes (10) sur le corps de support (1) ou des canaux de refroidissement à l'intérieur du corps de support (1).

5. Corps de support selon la revendication 3 ou 4, **caractérisé en ce que** le(s) niveau(x) supplémentaire(s) de métallisation porte(nt) des composants électroniques et/ou est(sont) structuré(s) pour former des résistances ou des bobines.

6. Corps de support selon l'une des revendications 3 à 5, **caractérisé en ce que** le corps de support est constitué de matériaux céramiques en alumine Al2O3 ou en nitrure d'aluminium AIN.

7. Corps de support selon l'une des revendications 3 à 6, **caractérisé en ce que** le niveau de métallisation supérieur, destiné à recevoir les éléments de circuit, est en cuivre et que les autres niveaux internes de métallisation sont en tungstène.
